# NEUE EUROPÄISCHE PATENTSCHRIFT

(11) **EP 0 418 403 B2**
(45) Veröffentlichungstag und Bekanntmachung des Hinweises auf die Entscheidung über den Einspruch: **30.06.1999**
(45) Hinweis auf die Patenterteilung: 20.07.1994
(21) Anmeldenummer: 89116725.6
(22) Anmeldetag: 09.09.1989
(51) Int. Cl.: H03J 9/06, H04N 5/445

(54) **Fernbedienungseinrichtung für Fernsehempfänger**
Remote control device for a television receiver
Dispositif de commande à distance pour récepteur de télévision

(43) Veröffentlichungstag der Anmeldung: 27.03.1991
(73) Patentinhaber: Micronas Intermetall GmbH, 79108 Freiburg (DE)
(72) Erfinder: Keller, Hans, Dipl.-Ing., D-7803 Gundelfingen (DE)
(74) Vertreter: Moncheny, Michel

(56) Entgegenhaltungen:
- EP-A- 44 385
- EP-A- 0 068 422
- EP-A- 0 167 737
- DE-A- 2 847 052
- GB-A- 2 062 987

## Beschreibung

Moderne Fernsehempfänger zeichnen sich durch eine Vielzahl von Steuerungsmöglichkeiten aus. Da ihre Steuerung vorwiegend über den Fernbedienungsgeber erfolgt, bedeutet dies, daß aus Kostengründen der Fernsehempfänger selbst lediglich mit einer einfachen Bedienung versehen ist, welche oft nur die sequentielle Programmschaltung und die Lautstärkeeinstellung ermöglicht. Dieser Zustand ist sehr unbefriedigend, weil damit die Bedienungsvielfalt des Fernsehempfängers stark eingeschränkt wird, wenn der Fernbedienungsgeber ausgefallen ist.

Die Hauptursache für Ausfälle des Fernbedienungsgebers ist das Nachlassen seiner Batteriespannung. Wenn man nun den Gerätebenutzer rechtzeitig darauf aufmerksam macht, daß er die Batterie auswechseln muß, dann wird er nicht plötzlich von der erheblichen Einschränkung der Bedienungsvielfalt überrascht. Beim Vorhandensein dieser Vorwarnung entfällt sogar die Notwendigkeit einer eigenen Bedienungseinheit am Gerät - der Netzschalter ist ausgenommen- , so daß das Fernsehgerät weiter vereinfacht und verbilligt werden kann.

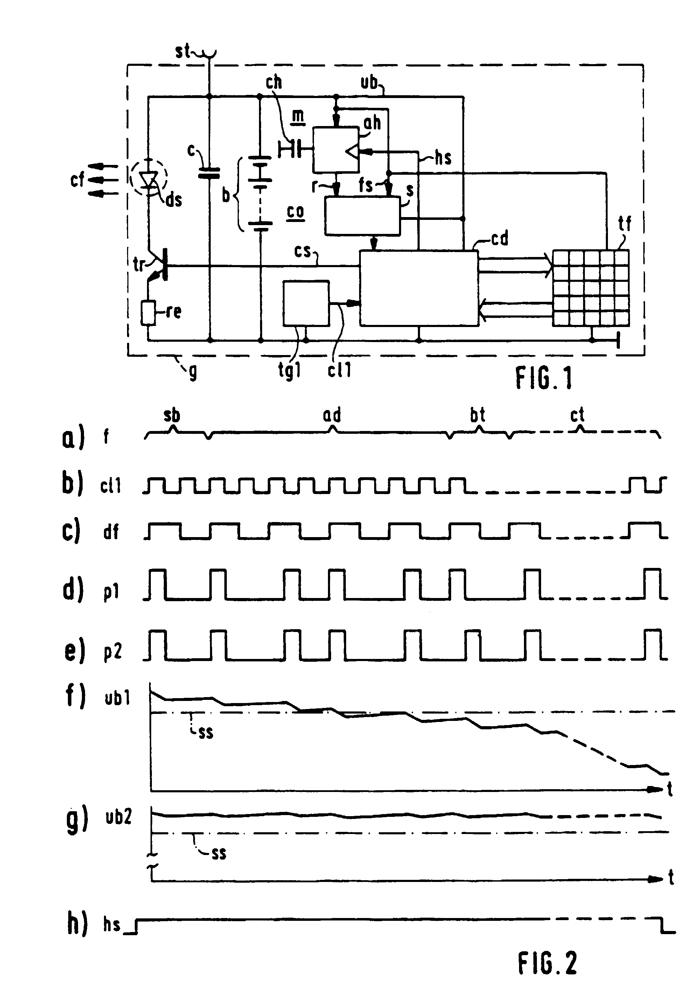

Eine Überwachungseinrichtung für den Batteriezustand einer Fernbedienungseinrichtung ist beispielsweise aus GB-A 2 062 987 bekannt. Dort ist eine Fernbedienungseinrichtung beschrieben, die mittels eines codemodulierten Fernbedienungssignals einen Fernsehempfänger steuert und die eine Batterieüberwachungseinrichtung enthält, die als Batteriewechselsignal ein entsprechendes Hinweissymbol auf einem 7-Segment-Display am Fernsehempfänger auslöst. Hierzu stellt eine Meßschaltung im Fernbedienungsgeber den Spannungseinbruch der Versorgungsbatterie unter Last fest und erzeugt mittels einer Bewertungsschaltung und eines Schwellwertdetektors ein Steuersignal für die im Fernbedienungsgeber enthaltene Codierschaltung. Beim Ansprechen des Schwellwertdetektors werden die codemodulierten Fernbedienungssignale, die von einem Tastenfeld auf dem Fernbedienungsgeber ausgelöst werden, durch ein zusätzliches achtes Bit modifiziert. Eine Dekodierschaltung im Fernsehempfänger spricht auf diese Codemodifikation an und löst daraufhin das bereits genannte Hinweissymbol für den Batteriewechsel am Fernsehempfänger aus, vgl. auch den Oberbegriff des Anspruchs 1 und Fig. 1.

In EP-A 0 044 385 ist eine Schaltung zum Einblenden eines Analogsignals, z.B in Form eines Balkens, oder eines alphanummerischen Zeichens auf dem Bildschirm eines Fernsehempfängers beschrieben. Die Steuerung der Anzeige erfolgt über einen taktgesteuerten Zeichengenerator, der über die Adresse eines Nur-Lese-Speichers die Einblendorte des jeweiligen Zeichens in horizontaler und vertikaler Richtung bestimmt. Mittels der Analogfunktion kann beispielsweise auch der Ladezustand einer im Fernsehempfänger eingebauten Batterie angezeigt werden.

Aus DE-A 2 847 052 ist ein Geber für eine Fernbedienung bekannt, dessen Betriebsanzeige unterbrochen wird, wenn die Betriebsspannung unter eine Schwelle absinkt.

Es ist Aufgabe der in den Ansprüchen gekennzeichneten Erfindung, die abnehmende Batterieleistung des Fernbedienungsgebers frühzeitig zu ermitteln und in verbesserter Form für den jeweiligen Bedienenden deutlich und unmißverständlich anzuzeigen, damit rechtzeitig eine Ersatzbatterie besorgt werden kann. Die Erfindung und weitere Vorteile werden nun anhand der Figuren der Zeichnung näher erläutert:
Fig. 1 zeigt schematisch das Blockschaltbild eines bekannten Fernbedienungsgebers mit einer Meßeinrichtung und eine Bewertungsschaltung für die Batterieleistung;
Fig. 2 zeigt einige charakteristische Zeitdiagramme zur Batterieüberwachung und Codemodifikation nach der Erfindung;
Fig. 3 zeigt schematisch als Blockschaltbild die für die Erfindung relevanten Teilschaltungen im Fernsehempfänger und
Fig. 4 zeigt als Beispiel, wie ein entsprechendes Hinweissymbol auf dem Bildschirm eingeblendet ist.

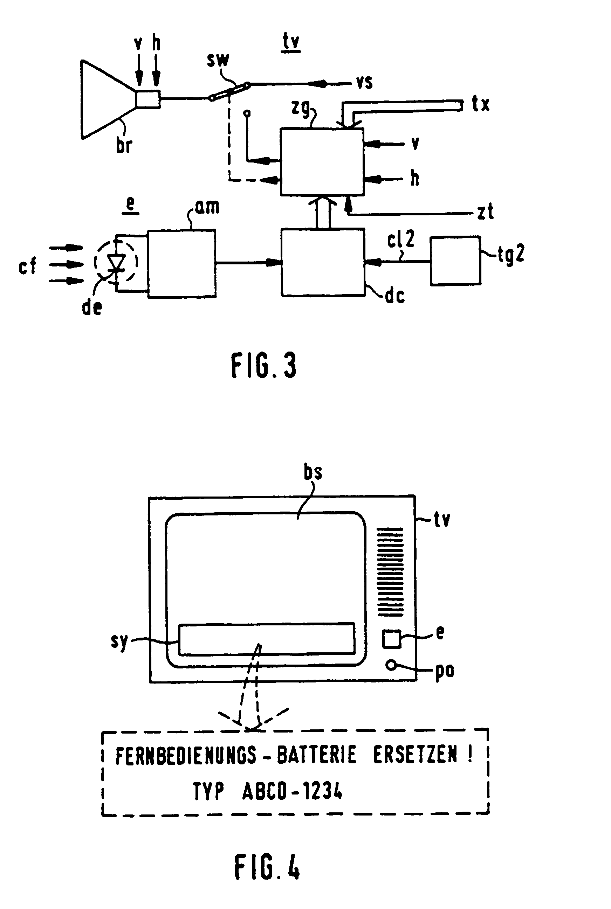

Das Blockschaltbild des Fernbedienungsgebers g in Fig. 1 enthält außer den üblichen Teilschaltungen eine Meßschaltung m für die Batterieleistung und eine Bewertungsschaltung co, welche die gemessene Batterieleistung mit einem Referenzwert r vergleicht. Das Ergebnis dieses Vergleichs steuert über eine übliche Codierschaltung cd den Code des abgegebenen Fernbedienungssignals cf. In dem Fernbedienungsgeber g nach Fig. 1 wird wie üblich die Infrarot-Sendediode ds über einen Schalttransistor tr aus der Batterie b gespeist, der ein Pufferkondensator c von beispielsweise 1000 Mikrofarad, parallel liegt. Zur Emittlung der jeweils gedrückten Taste ist das Tastenfeld tf an einen Steuerbus der Codierschaltung cd angeschlossen. Die tastenabhängigen Signale des Tastenfeldes tf sind der Codierschaltung über einen weiteren Steuerbus zugeführt. Die zeitliche Steuerung der Codierschaltung cd erfolgt durch den Taktgeber tg1, der einen Takt cl1 vorgegebener Taktfrequenz erzeugt. Diesem Taktgeber entspricht auf der Empfängerseite der Taktgeber tg2, der an die Decodierschaltung dc angeschlossen ist und dessen Takt c12 die gleiche Taktfrequenz aufweist (vgl. Fig. 3).

In dem Ausführungsbeispiel nach Fig. 1 besteht die Meßschaltung m aus einer Abtasthalteschaltung ah mit einem Haltekondensator ch, deren Fühlereingang an die Batteriespannung ub angeschlossen ist. Die Abtasthalteschaltung wird mittels eines Haltesignals hs aktiviert, das von der Codierschaltung cd als weiteres Steuersignal abgegeben wird. Das Raltesignal hs wird bei Betätigung einer Taste ausgelöst. Da durch die Abtasthalteschaltung ah der Anfangswert der Batteriespannung ub gespeichert ist, also ohne Belastung, kann dieser Wert zu einem späteren Zeitpunkt mit der Batteriespannung ub verglichen werden, wenn die Batterie b bereits durch einen oder mehreren Sendeimpulse belastet wurde. Dieser Vergleich findet in der Bewertungsschaltung co statt, die beispielsweise aus einem Schwellwertdedektor s besteht, dessen Vergleichseingang mit der Batteriespannung ub und dessen Referenzeingang mit dem Ausgangssignal der Abtasthalteschaltung ah gespeist sind. Liegt das Fühlersignal fs unterhalb einer mit dem Referenzsignal r mitlaufenden Schaltschwelle ss, dann nimmt das Ausgangssignal des Schwellwertdedektors s einen ersten Zustand ein, welcher der Codierschaltung cd anzeigt, daß die Versorgungsbatterie b schwach ist (vgl. auch Fig. 2f).

Ist die Versorgungsbatterie b in Ordnung, dann wird die Schaltschwelle ss nicht unterschritten und der Schwellwertdedektor s liefert ein zweites Zustandssignal an die Codierschaltung cd (vgl. Fig. 2g).

Als Maß für den Batteriezustand kann auch der Strom durch den LED-Treibertransistors tr dienen, wobei dann der Fühlereingang der Abtasthalteschaltung ah an einen Widerstand re im Emitter des Transistors angeschlossen ist. Unter Umständen ist dieses Meßverfahren für den Batteriezustand noch günstiger, weil für die Bestimmung des Referenzsignals r die Versorgungsbatterie b bereits belastet wird und die zeitliche Spannungsabnahme unter Last somit besser bestimmbar ist. Die Schaltschwelle ss und das Referenzsignal r können bei der Strommessung auch identisch und beispielsweise aus einer Referenzspannungsquelle abgeleitet sein.

Eine besonders einfache Ausführung der Meßschaltung m und der Bewertungsschaltung co ergibt sich, wenn beide Teil der Codierschaltung cd sind. Es reicht dann aus, daß eines der internen Logikgatter zur Bildung des Batterieüberwachungsbits (vgl. Batterieüberwachungsteil bt in Fig. 2) mit einer leicht erhöhten Schwellenspannung versehen ist, so daß bei abnehmender Batteriespannung ub diese Schwelle vom vorausgehenden Logikgatter nicht mehr überschritten wird. Somit registriert diese spezielle Logikstufe immer als erste Stufe den kritischen Batteriezustand, bevor die übrigen Schaltungsteile der Codierschaltung cd ausfallen.

In Fig. 2 sind schematisch einige Zeitdiagramme dargestellt, welche die Funktionsweise der Batterieüberwachungseinrichtung erläutern.

Das Zeitdiagramm Fig.2a zeigt das Format f des codemodulierten Fernbedienungssignals cf, mit Startbit sb, Adressteil ad, Batterieüberwachungsteil bt und Befehlsteil ct. Der zugehörige Takt cl1 ist darunter als Zeitdiagramm Fig. 2b wiedergegeben. Im Zeitdiagramm Fig. 2c sind in Pulsform die Zeitfenster df dargestellt, in denen ein Bit gesendet oder empfangen werden kann. Dies ist in dem gezeigten Beispiel nur möglich, wenn das Zeitfenster df den oberen Logikpegel aufweist. Als codemodulierte Fernbedienungssignale cf können PCM-Signale ausgesendet werden, bei denen je nach dem logischen Zustand "H" bzw. "L" des jeweiligen Bit "ein Puls" bzw. "kein Puls" ausgesendet wird. Da dieser Code bei der Übertragung störungsanfällig ist, ist ein phasenmoduliertes PCM-Signal p1, p2 vorzuziehen, wie es im Zeitdiagramm Fig. 2d und Fig. 2e dargestellt ist. Dabei wird in jedem möglichen Zeitfenster df ein Puls ausgesendet, dessen Phasenlage jedoch jeweils nach dem Logikzustand variert ist.

Der Batterieüberwachungsteil bt im Format f des Fernbedienungssignals cf braucht nur ein Bit zu umfassen. Dieses Bit ist zweckmäßigerweise hinter dem Startbit sb oder dem Adressteil ad angeordnet, so daß der Batteriezustand auch dann noch dem Fernsehempfänger tv übertragbar ist, wenn die Batterieleistung soweit abgesunken ist, daß der Befehlsteil ct nicht mehr vollständig übertragen wird. Der Batterieüberwachungsteil bt löst dann auf dem Bildschirm bs immer noch das Hinweissymbol sy für den erforderlichen Batteriewechsel aus.

Im Zeitdiagramm Fig. 2f ist anhand der Batteriespannung ubl dargestellt, wie bei verbrauchter Versorgungsbatterie beispielsweise bereits nach vier Sendeimpulsen die Schaltschwelle ss unterschritten wird. Im Zeitdiagramm Fig. 2g ist dargestellt, wie bei einer unverbrauchten Versorgungsbatterie b die Batteriespannung ub2 trotz der Sendeimpulse oberhalb der vorgegebenen Schaltschwelle ss bleibt und daher kein Batteriewechselsignal auslöst.

Im letzten Zeitdiagramm Fig. 2h ist das Haltesignal hs dargestellt, das mit seiner Anstiegsflanke die Abtasthalteschaltung ah aktiviert und solange im Haltezustand hält bis das Haltesignal hs wieder abfällt. Durch die zeitliche Lage der Anstiegsflanke kann bestimmt werden, ob die festzuhaltende Batteriespannung unter Last oder ohne Last - also im Leerlauf - festgehalten wird. Im Zeitdiagramm Fig. 2h ist dies für den Leerlauffall dargestellt.

Bei den für die Erfindung erforderlichen Teilschaltungen im Fernsehempfänger kann auf die üblichen Teilschaltungen zurückgegriffen werden, wenn der Fernsehempfänger bereits mit einem Zeichengenerator zg ausgerüstet ist, wie er beispielsweise für den Teletextempfang erforderlich ist. Zusätzlich zum Teletextsignal tx wird der Zeichengenerator zg von der Decodierschaltung dc angesteuert, die aus dem zweiten Taktgenerator tg2 mit dem Takt cl2 versorgt wird.

Der Eingang der Decodierschaltung dc ist vom Verstärker am gespeist, der Teil der elektrischen Empfangseinrichtung e ist, die aus dem codemodulierten Fernbedienungssignal cf mittels der Infrarot-Empfangsdiode de ein serielles Datensignal bildet.

Die Zeichendarstellung auf dem Bildschirm ist mit dem Vertikal- und dem Horizontalsignal v, h synchronisiert, so daß dem Zeichengenerator zg diese Signale ebenfalls als Synchronisationssignale zugeführt sind. Der Zeichengenerator zg ist ferner mit dem Zeichentakt zt gespeist, der die Zeichenauflösung auf dem Bildschirm bestimmt. Die R-, G-B-Kathoden sind über einen elektronischen Mehrebenenumschalter sw entweder an das Videosignal vs oder an die Ausgänge des Zeichengenerators zg geschaltet. Der Steuereingang des elektronischen Umschalters sw ist an einem Steuerausgang des Zeichengenerators zg angeschlossen.

In Fig. 4 ist schematisch die Aufsicht auf einen Fernsehempfänger tv dargestellt, auf dessen Bildschirm bs ein Rinweissymbol sy für den Batteriewechsel eingeblendet ist. Die Wiedergabedauer dieses Hinweissymboles sy ist dabei von der Programmierung des Zeichengenerators zg abhängig.

## Patentansprüche

1. Fernbedienungseinrichtung, die mittels eines codemodulierten Fernbedienungssignals (cf) einen Fernsehempfänger (tv) steuert und die eine Batterieüberwachungseinrichtung enthält, die aus folgenden Teilschaltungen besteht:
- eine Meßschaltung (m) im Fernbedienungsgeber (g), die den Spannungseinbruch der Versorgungsbatterie (b) unter Last feststellt,
- eine Bewertungsschaltung (co) im Fernbedienungsgeber (g) mit einem Schwellwertdedektor (s), dem ein Fühlersignal (fs) aus der Meßschaltung und ein Referenzsignal (r) zugeführt sind,
- eine Codierschaltung (cd) im Fernbedienungsgeber (g), die codemodulierte Signale (cs) erzeugt und die eingangsseitig von einem Tastenfeld (tf) und dem Schwellwertdedektor (s) gespeist ist, wobei die codemodulierten Signale (cs) durch den jeweiligen Zustand des Schwellwertdedektors (s) in ihrem Code modifiziert sind, und
- eine Decodierschaltung (dc) im Fernsehempfänger (tv), die auf diese Codemodifikation anspricht und als Batteriewechselsignal ein entsprechendes Hinweissymbol (sy) am Fernsehempfänger (tv) auslöst,
dadurch gekennzeichnet, daß
- das Hinweissymbol (sy) für den Batteriewechsel in deutlich sichtbarer Form auf einem Bildschirm (bs) des Fernsehempfängers (tv) dargestellt ist,
- das Hinweissymbol (sy) einen mehrere Zeichen umfassenden Hinweis für den Batteriewechsel enthält und
- die Wiedergabe auf dem Bildschirm (bs) mittels eines programmierten Zeichengenerators (zg) für Teletextsignale (tx) von der Decodierschaltung (dc) gesteuert ist.

2. Fernbedienungseinrichtung nach Anspruch 1, wobei das codemodulierte Fernbedienungssignal (cf) als pulscodemoduliertes Signal (= PCM-Signal) (p1; p2) mit einem Startbit (sb) einem Adressteil (ad), einem Batterieüberwachungsteil (bt) und einem Befehlsteil (ct) ausgebildet ist.

3. Fernbedienungseinrichtung nach Anspruch 2, wobei das PCM-Signal ein phasenmoduliertes PCM-Signal (p1; p2) ist (Fig. 2).

4. Fernbedienungseinrichtung nach Anspruch 1 mit einer Abtasthalteschaltung (ah), welche den Wert der ungeregelten Batteriespannung (ub) zu Beginn des codemodulierten Fernbedienungssignals (cf) festhält und deren Steuereingang mit einem Haltesignal (hs) von der Codierschaltung (cd) gesteuert ist, wobei der Referenzeingang des Schwellwertdedektors (s) mit dem Ausgang der Abtasthalteschaltung (ah) und der Vergleichseingang des Schwellwertdedektors (s) mit dem Fühlereingang der Abtasthalteschaltung (ah) gekoppelt ist.

5. Fernbedienungseinrichtung nach Anspruch 1, wobei statt der Batteriespannung (ub) über einen Fühlwiderstand der unter Last abnehmende Strom der Infrarot-Sendediode (ds) gemessen und mit einem festen Referenzwert, insbesondere mit dem Anfangs-Strom, verglichen wird.

6. Fernbedienungseinrichtung nach Anspruch 5, wobei als Maß für den Strom durch die IR-Diode der Spannungsabfall an einem Widerstand (re) im Emitter des LED-Treibertransistors (tr) dient.

7. Fernbedienungseinrichtung nach Anspruch 1, wobei der Fernsehempfänger (tv) ausschließlich über den Fernbedienungsgeber(g) bedienbar ist und außer einem Netzschalter (po) keinerlei weitere Bedienungseinrichtungen aufweist.

8. Fernbedienungseinrichtung nach Anspruch 7, wobei die Versorgungsbatterie (b) über einen Niederspannungsstecker (st) aus dem Fernsehempfänger (tv) nachladbar ist.

9. Fernbedienungseinrichtung nach Anspruch 1, wobei mit dem Hinweissymbol (sy) auf dem Bildschirm (bs) für den erforderlichen Batteriewechsel der erforderliche Batterietyp angezeigt ist (Fig. 4).

10. Fernbedienungseinrichtung nach Anspruch 1, dadurch gekennzeichnet, daß als Meß- und als Bewertungsschaltung (m, co) ein Logikgatter in der Codierschaltung (cd) zur Bildung des Batterieüberwachungsbits dient, wobei dieses Logikgatter mit einer höheren Schwellenspannung versehen ist als die übrigen Teilschaltungen der Codierschaltung (cd).

## Claims

1. A remote-control system which controls a television receiver (tv) by means of a code-modulated remote-control signal (cf) and includes a battery-monitoring facility consisting of the following subcircuits:
- a measuring circuit (m) in the remote-control transmitter (g) which senses the drop in the voltage of the battery (b) under load conditions;
- an evaluating circuit (co) in the remote-control transmitter (g) comprising a threshold detector (s) to which a sense signal (fs) from the measuring circuit and a reference signal (r) are applied;
- an encoder (cd) in the remote-control transmitter (g) which generates code-modulated signals (cs) and is fed from a keyboard (tf) and the threshold detector (s), with the code of the code-modulated signals (cs) being modified by the respective state of the threshold detector (s), and
- a decoder (dc) in the television receiver (tv) which responds to said code modification and causes a symbol (sy) indicating the need for a battery replacement to be displayed at the television receiver (tv),
characterized in
- that the symbol (sy) indicating the need for a battery replacement is displayed in clearly visible form on a screen (bs) of the television receiver (tv),
- that the symbol (sy) indicating the need for a battery replacement comprises several characters, and
- that the display on the screen (bs) is controlled by means of a programmed character generator (zg) which is driven by teletext signals (tx) and the decoder (dc).

2. A remote-control system as claimed in claim 1 wherein the code-modulated remote-control signal (cf) is a pulse-code-modulated signal (= PCM signal) (pl; p2) consisting of a start bit (sb), an address part (ad), a battery-monitoring part (bt), and a command part (ct).

3. A remote-control system as claimed in claim 2 wherein the PCM signal is a phase-modulated PCM signal (pl, P2) (Fig. 2).

4. A remote-control system as claimed in claim 1, comprising a sample-and-hold circuit (ah) which holds the value of the unregulated battery voltage (ub) at the beginning of the code-modulated remote-control signal (cf) and whose control input is controlled by a hold signal (hs) from the encoder (cd), with the reference and compare inputs of the threshold detector (s) connected to the output and the sense input, respectively, of the sample-and-hold circuit (ah).

5. A remote-control system as claimed in claim 1 wherein instead of the battery voltage (ub), the current of the infrared-emitting diode (ds), which decreases under load conditions, is measured via a sensing resistor and compared with a fixed reference value, particularly with the initial current.

6. A remote-control system as claimed in claim 5 wherein the voltage drop across a resistor (re) in the emitter of the LED driver transistor (tr) serves as a measure of the current flowing through the IR diode.

7. A remote-control system as claimed in claim 1 wherein the television receiver (tv) is controllable exclusively via the remote-control transmitter (g) and has no controls except for a power switch (po).

8. A remote-control system as claimed in claim 7 wherein the battery is rechargeable from the television receiver (tv) via a low-voltage plug (st).

9. A remote-control system as claimed in claim 1 wherein the on-screen symbol (sy) indicating the need to replace the battery also indicates the necessary battery type (Fig. 4).

10. A remote-control system as claimed in claim 1, characterized in that the measuring and evaluating circuits (m, co) are constituted by a logic gate in the encoder (cd) for forming the battery-monitoring bit, said logic gate being provided with a higher threshold voltage than the other subcircuits of the encoder (cd).

## Revendications

1. Dispositif de télécommande, qui commande un récepteur de télévision (tv) au moyen d'un signal de télécommande (cf) modulé par un code, et qui contient un dispositif de contrôle d'une pile, ce dispositif de télécommande étant constitué par les éléments de circuit suivants :
- un circuit de mesure (m) situé dans le générateur de télécommande (g) et qui détecte l'interruption de tension de la pile d'alimentation sollicitée par une charge,
- un circuit d'évaluation (co) situé dans le générateur de télécommande (g) et comportant un détecteur à valeur de seuil (s), auquel sont envoyés un signal de détection (fs) provenant du circuit de mesure et un signal de référence (r),
- un circuit de codage (cd) situé dans le générateur de télécommande (g) et qui produit les signaux (cs) modulés par un code et est alimenté, côté entrée, à partir d'un clavier (tf) et du détecteur à valeur de seuil (s), dans lequel les signaux (cs) modulés par un code, sont modifiés par l'état respectif du détecteur à valeur de seuil (s) dans leur code, et un circuit de décodage (dc) situé dans le récepteur de télévision (tv), qui répond à cette modification du code et délivre un symbole d'indication (sy) sur le récepteur de télévision (tv) comme signal de changement de pile,
caractérisé en ce que
- le symbole d'indication (sy) pour le changement de pile est représenté sur l'écran (bs) du récepteur de télévision (tv) sous une forme nettement visible,
- le symbole d'indication (sy) contient une indication comportant plusieurs signes pour le changement de pile et,
- la représentation sur l'écran (bs) est pilotée par le circuit de décodage (dc) au moyen d'un générateur de caractères (zg) programmé pour signaux de télétextes (tx).

2. Dispositif de télécommande suivant la revendication 1, dans lequel le signal de télécommande (cf) modulé par un code est réalisé sous la forme d'un signal modulé selon une modulation par impulsions codées (= signal MIC) (p1; p2) avec un bit de démarrage (sb), une partie d'adresse (ad), une partie (bt) de contrôle de la pile et une partie d'instruction (ct).

3. Dispositif de télécommande suivant la revendication 2, dans lequel le signal MIC est un signal MIC modulé en phase (p1; p2) (figure 2).

4. Dispositif de télécommande suivant la revendication 1, comportant un circuit d'échantillonnage et de blocage (ah), qui bloque la valeur de la tension non réglée (ub) de la pile au début du signal de télécommande (cf) modulé par le code, et dont l'entrée de commande est commandée avec un signal de blocage (hs), par le circuit de codage (cd), l'entrée de référence du détecteur à valeur de seuil (s) étant couplée à la sortie du circuit d'échantillonnage et de blocage (ah), tandis que l'entrée de comparaison du détecteur à valeur de seuil (s) est couplée à l'entrée de détection du circuit d'échantillonnage ou de blocage (ah).

5. Dispositif de télécommande selon la revendication 1, dans lequel, à la place de la tension (ub) de la pile, le courant, qui diminue sous la sollicitation d'une charge, de la diode d'émission à infrarouge (ds) est mesuré par l'intermédiaire d'une résistance de détection et est comparé à une valeur de référence fixe, notamment au courant initial.

6. Dispositif de télécommande suivant la revendication 5, selon lequel en tant que mesure du courant traversant la diode à infrarouge, on utilise la chute de tension dans une résistance (re) située dans l'émetteur du transistor d'attaque (tr) à diode LED.

7. Dispositif de télécommande suivant la revendication 1, selon lequel le récepteur de télévision (tv) peut être commandé exclusivement par l'intermédiaire du générateur de télécommande (g) et ne possède aucun autre type de dispositif de commande en dehors d'un interrupteur (po) de raccordement du réseau.

8. Dispositif de télécommande suivant la revendication 7, dans lequel la pile d'alimentation (b) peut être rechargée par l'intermédiaire d'un connecteur à basse tension (st) à partir du récepteur de télévision (tv).

9. Dispositif de télécommande suivant la revendication 1, dans lequel le symbole indicateur (sy) est affiché sur l'écran (bs) pour le changement nécessaire de type de pile requis (figure 4).

10. Dispositif de télécommande suivant la revendication 1, caractérisé en ce qu'on utilise comme circuit de mesure et d'évaluation (m, co), une porte logique située dans le circuit de codage (cd) pour la formation du bit de contrôle de la pile, cette porte logique comportant une tension de seuil supérieure à celle des autres éléments du circuit de codage (cd).
